Europäisches Patentamt

European Patent Office

Office européen des brevets

(11) Numéro de publication : **0 422 985 B1**

## (12) FASCICULE DE BREVET EUROPEEN

(45) Date de publication du fascicule du brevet :
**05.05.93 Bulletin 93/18**

(51) Int. Cl.$^5$ : **G01V 3/26**, G01R 33/16

(21) Numéro de dépôt : **90402721.6**

(22) Date de dépôt : **02.10.90**

(54) *Procédé et dispositif de détection des inversions du champ magnétique terrestre par mesures dans un trou de forage.*

(30) Priorité : **10.10.89 FR 8913199**

(43) Date de publication de la demande :
**17.04.91 Bulletin 91/16**

(45) Mention de la délivrance du brevet :
**05.05.93 Bulletin 93/18**

(84) Etats contractants désignés :
**BE DE FR GB IT NL**

(56) Documents cités :
**GB-A- 2 158 950**
**US-A- 3 453 531**
**US-A- 3 965 412**
**US-A- 4 071 815**

(73) Titulaire : **TOTAL COMPAGNIE FRANCAISE DES PETROLES Société Anonyme**
**5, rue Michel Ange**
**F-75781 Paris Cédex 16 (FR)**
Titulaire : **COMMISSARIAT A L'ENERGIE ATOMIQUE**
**31/33, rue de la Fédération**
**F-75015 Paris (FR)**

(72) Inventeur : **Augustin, Antoine**
**6, rue Pierre Dupont**
**F-38000 Grenoble (FR)**
Inventeur : **Pocachard, Jacques**
**429, Rue Berlioz**
**F-38340 Voreppe (FR)**
Inventeur : **Bouisset, Patrick**
**77, rue Crozatier**
**F-75012 Paris (FR)**

(74) Mandataire : **Jolly, Jean-Pierre et al**
**Cabinet Jolly 54, rue de Clichy**
**F-75009 Paris (FR)**

**Description**

La présente invention concerne un procédé permettant de déterminer l'aimantation rémanente des roches traversées par un trou de forage afin de localiser les zones d'inversion du champ magnétique terrestre.

Le champ magnétique terrestre est actuellement orienté vers le nord, mais au cours des temps géologiques, il a basculé un grand nombre de fois entre le nord et le sud. Les roches possèdent une aimantation qui peut être décomposée en deux termes : une partie est induite par le champ magnétique terrestre et est appelée aimantation induite ; l'autre partie correspond à la mémorisation du champ magnétique terrestre au moment du dépôt et/ou de la formation des roches et est dans la direction et le sens de ce champ magnétique terrestre ; cette dernière fraction est appelée aimantation rémanente. On peut considérer que les inversions du sens de l'aimantation rémanente détectées au cours d'un forage dans les couches rocheuses successives, reflètent fidèlement les inversions de sens du champ magnétique terrestre qui se sont produites entre les époques où les couches se sont déposées.

La détection des inversions permet donc de dater les roches. Dans le domaine du forage de puits pétroliers, la connaissance de l'âge des roches est de la plus grande importance puisqu'elle permet d'établir une corrélation entre les couches.

On connaît déjà des procédés de détection des inversions du champ magnétique terrestre. Le procédé le plus commun consiste à prélever une multitude d'échantillons de roches le long du trou de forage, à les remonter à la surface et à en effectuer en laboratoire une analyse magnétique en vue de déterminer leur aimantation rémanente. Mais cette procédure est longue et coûteuse et de plus, les échantillons acquièrent, lorsqu'ils sont remontés à la surface, un magnétisme parasite influencé par le magnétisme terrestre et par le changement de température.

C'est pourquoi, on a créé par le passé toute une famille de sondes de mesures magnétiques appelées magnétomètres ou magnétogradiomètres qui permettent de déterminer in situ le magnétisme des roches à mesure que ladite sonde se déplace dans le trou de forage, celle-ci étant reliée à une unité de traitement de données disposée à la surface.

Des exemples de telles sondes sont décrites dans le brevet GB-A-2 158 950, US-A-3 453 531 et US-A-3 965 412. Lorsqu'on opère sur des roches fortement aimantées, l'induction créée dans le puits par l'aimantation rémanente est suffisamment importante pour être détectée directement. Mais dans le domaine des sondages pétroliers, les roches en présence sont très faiblement aimantées, à de rares exceptions près. Or il est nécessaire de connaître la valeur de l'induction magnétique avec une grande précision.

Les inductions en jeu étant de l'ordre de 1 à 10 nanoteslas (nT), il est souhaitable de les connaître avec une précision inférieure au nT.

Il existe des magnétomètres triaxiaux très précis qui permettent de déterminer l'induction magnétique par restitution à partir des trois composantes, mais le manque de précision de la technique rend difficile l'opération dans le domaine des forages pétroliers. Ce manque de précision n'est pas lié aux caractéristiques intrinsèques du magnétomètre, mais plutôt au procédé de détection.

Par le brevet US 4 071 815, on connaît un procédé de détection des inversions du champ magnétique selon le préambule de la revendication 1. Ce procédé consiste à effectuer deux mesures simultanées du champ magnétique total $B_1$ et $B_2$ dans le trou de forage en deux points distincts, et deux mesures de la susceptibilité magnétique terrestre $X_1$ et $X_2$ aux mêmes points, à calculer les différences dif B= $B_1$ - $B_2$ et dif X= $X_1$ - $X_2$ et à calculer enfin la quantité R= dif B- dif X qui est représentative de la fraction d'aimantation rémanente présente dans la roche au niveau de ces deux points.

Ce procédé connu est valable, mais il souffre d'un manque d'optimisation qui permettrait d'exploiter la grandeur R qui, comme on l'a indiqué ci-dessus, ne contient qu'une fraction de l'information sur l'aimantation rémanente.

La présente invention a pour but de remédier aux inconvénients des procédés de la technique antérieure exposée ci-dessus. Elle concerne un procédé de relevé de mesures du champ magnétique dans un puits de forage, ainsi que le traitement de ces mesures en vue de déterminer de façon concrète les zones à polarités inverses et normales traversées par le trou de forage. Une zone à polarité normale est une zone où l'aimantation rémanente dans la roche est orientée dans le même sens que le champ magnétique terrestre actuel et inversement dans une zone à polarité inverse, l'aimantation rémanente de la roche est déphasée de 180° par rapport au champ magnétique terrestre actuel.

L'invention concerne un procédé selon le préambule de la revendication 1, et qui se caractérisé en ce qu'il consiste :

- à effectuer lesdites mesures de l'induction magnétique et de la susceptibilité en un grand nombre de points tout le long du trou de forage par remontée en continu d'un appareil de mesure ;
- à mesurer simultanément les variations de l'induction magnétique $B_2$ en un point fixe situé à la surface du sol,
- à former la grandeur $B_1$-$B_2$ afin d'éliminer les influences des variations temporelles du champ magnétique terrestre sur l'induction magnétique $B_1$ mesurée dans le trou ;
- à effectuer un filtrage de ladite grandeur afin d'éliminer la fraction d'induction due aux sources magnétiques lointaines, et d'isoler ainsi la fraction restante d'induction $B_L$ qui comprend une composante $B_I$ due à l'aimantation induite et une composante $B_R$ due à l'aimantation rémanente ;

- à déduire des mesures de l'induction $B_1$ et de la susceptibilité magnétique X, l'induction $B_I$ ;
- et enfin à déduire des inductions $B_L$ et $B_I$ ainsi obtenues, l'influence des changements d'orientation de l'aimantation rémanente.

L'invention concerne également un dispositif permettant d'effectuer le traitement des informations obtenues sur les inductions $B_L$ et $B_I$ en vue d'en déduire le sens de l'aimantation rémanente.

La méthode de détection des inversions de l'aimantation rémanente sera expliquée à présent plus en détail dans la description qui va suivre, faite en regard des dessins annexés dans lesquels :

La figure 1 représente sur le même schéma des exemples de courbes de variations de l'induction $B_L$ et de l'induction $B_I$ en fonction de la profondeur z ;

Les figures 2a, 2b et 2c illustrent un premier procédé de détection des inversions de l'induction rémanente par translation de chaque pic de la courbe de l'induction $B_I$ de la figure 1 pour l'amener en superposition avec le pic correspondant de l'induction $B_L$;

La figure 3 représente un exemple de diagramme résumant les résultats obtenus dans un trou de forage ;

La figure 4 illustre un second procédé de détection des inversions de l'induction rémanente par calcul de la dérivée des inductions $B_L$ et $B_L$ et comparaison des pentes moyennes des évolutions de $B_I$ et de $B_L$ sur des échelles de profondeur variables ;

Les figures 5a et 5b représentent schématiquement les appareils de mesure, et leur position.

Comme on l'a expliqué précédemment, on mesure d'une part l'induction magnétique terrestre $B_1$ et la susceptibilité magnétique X le long du trou de forage et d'autre part l'induction magnétique $B_2$ à la surface du sol.

On sait que l'induction $B_1$ est de la forme :

$$B_1 = B_O + B_L + B_T$$

où $B_O$ est l'induction liée aux influences magnétiques lointaines,

$B_L$ est l'induction liée aux influences magnétiques proches (aimantation induite et aimantation rémanente),

$B_T$ est l'induction liée aux variations temporelles du champ magnétique terrestre.

Il va de soi que l'induction $B_2$ à la surface est de la forme $B_2 = B_{T'}$ étant donné que l'influence des sources lointaines et des sources proches est négligeable.

La première opération de traitement en surface consiste à isoler le paramètre $B_L$. On calcule pour cela :

$$B_1 - B_2 = B_O + B_L + (B_T - B_{T'})$$

Pour des roches faiblement conductrices, ce qui est le cas dans le domaine géologique pétrolier, on peut identifier $B_T$ et $B_{T'}$ sans dégradation des résultats jusqu'à une profondeur de 2000 mètres. Au delà, il est nécessaire de considérer l'atténuation créée par les couches susjacentes.

En raison de ses origines, l'induction $B_O$ possède des variations de plus grande longueur d'onde que l'induction $B_L$. Grâce à un filtrage approprié, on peut donc séparer convenablement $B_L$ et $B_O$. On dispose donc ainsi de $B_L$ et ceci avec une grande précision. On rappelle que l'information contenue dans la grandeur $B_L$ concerne en partie l'aimantation induite $B_I$ et pour une autre partie l'aimantation rémanente $B_R$.

D'autre part, de la mesure de $B_1$ on peut déterminer avec une grande précision l'induction $B_I$ créée par l'aimantation induite des roches traversées par le trou de forage par la formule :

$$B_I = X B_1 k$$

où k est le facteur de couplage entre X et l'induction dans le puits, dépendant de la géométrie de la formation et du puits.

A partir de ce stade, deux techniques peuvent être mises en oeuvre pour détecter les inversions de l'aimantation rémanente, ces techniques s'appuyant sur des arguments théoriques et expérimentaux.

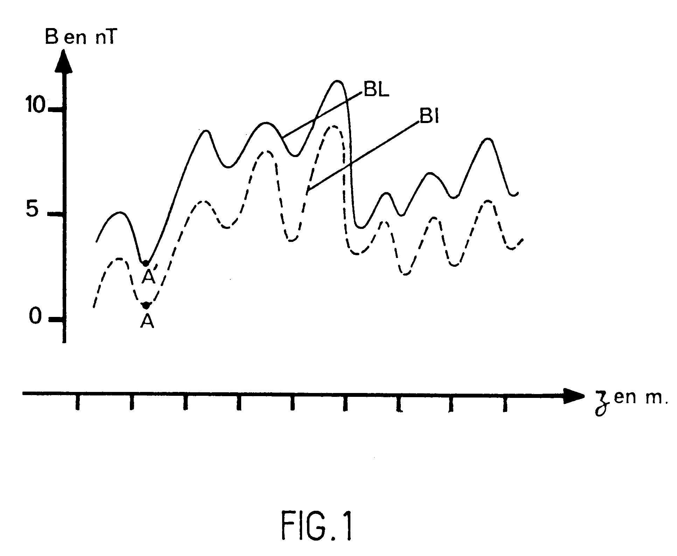

L'une de ces techniques consiste à tracer les diagraphies de $B_L$ et $B_I$ (en nT) en fonction de la profondeur z (en m). La figure 1 représente un exemple de ces diagraphies. Comme on le constate, les pics et les creux de $B_L$ et $B_I$ ont une périodicité déterminée (de l'ordre du mètre par exemple). Un pic est déterminé comme correspondant à une augmentation de l'aimantation dans la formation.

Pour chacun des pics, on prend comme origine de la courbe $B_L$, le point A' où l'induction est la plus faible, et comme origine de la courbe $B_I$, le point correspondant A à la même profondeur. On fait subir à la période de courbe $B_I$ une translation $\overrightarrow{AA'}$, ce qui amène donc le point A' en coïncidence avec A. Plusieurs configurations peuvent alors se présenter, dont on ne considérera ci-après que quelques exemples avec les interprétations qui en découlent pour une configuration des champs magnétiques identique à celle rencontrée dans le Bassin Parisien. Il est à noter que pour d'autres configurations des champs magnétiques, rencontrées dans d'autres parties du globe, les interprétations seront différentes mais basées sur le même principe d'analyse des courbes.

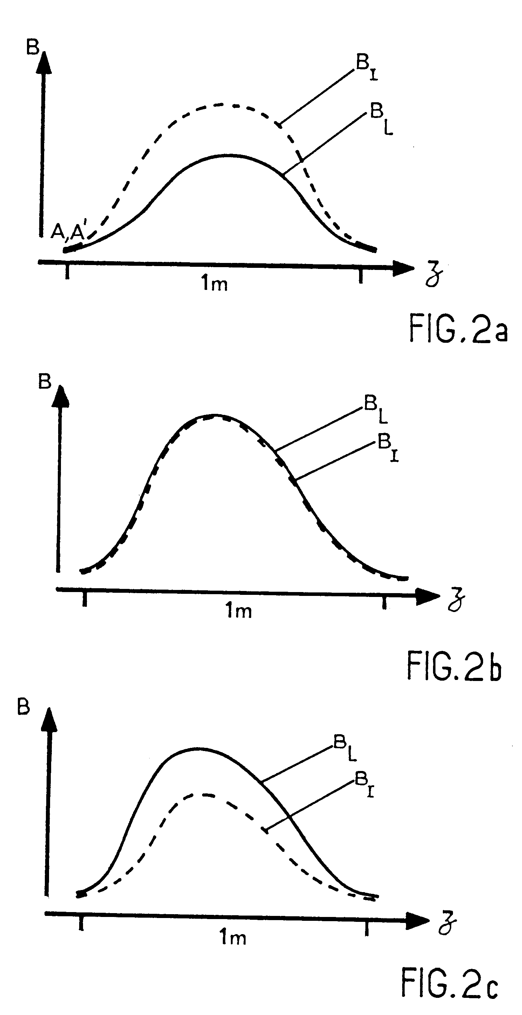

1- La courbe $B_I$ se trouve au-dessus de la courbe $B_L$ (figure 2a) : l'augmentation de $B_I$ est atténuée par $B_R$. La partie rémanente $B_R$ comprise dans $B_L$ est donc antagoniste de $B_I$ ; l'aimantation rémanente dans la formation est opposée à l'aimantation induite. On dit que l'aimantation rémanente est inverse.

2- La courbe $B_I$ translatée est confondue avec la courbe $B_L$ (figure 2b) : il y a indétermination sur la direction de $B_R$.

3- La courbe $B_I$ translatée est en dessous de la courbe $B_L$ (figure 2c), ce qui signifie que l'augmentation de $B_I$ est renforcée par $B_R$. Il en résulte que l'aimantation rémanente dans la formation est dans le sens de l'aimantation induite. On dit que l'aimantation rémanente est normale.

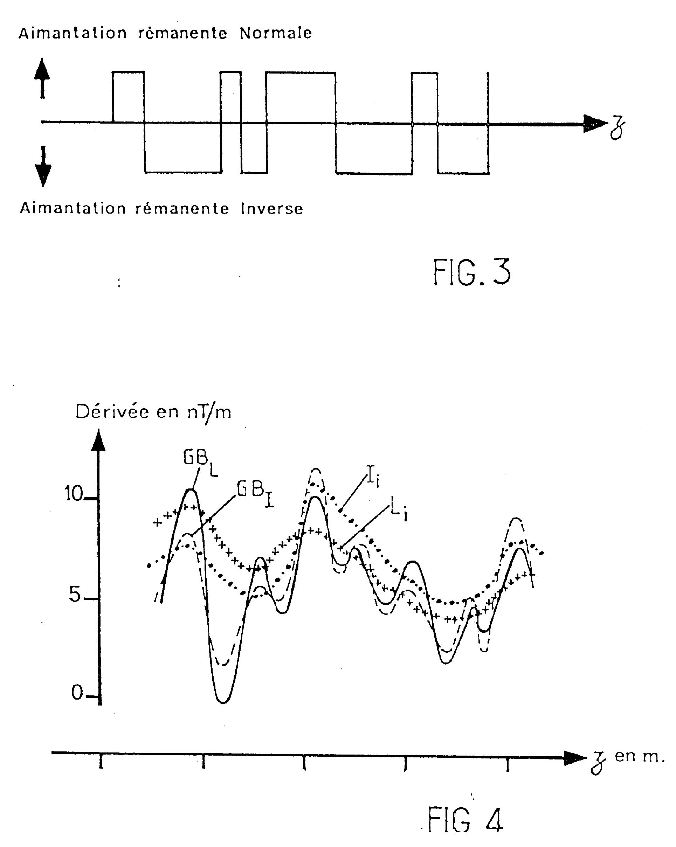

On procède de la même façon pour chaque pic des diagraphies $B_L$ et $B_I$. Tous les résultats obtenus peuvent être ensuite résumés dans le diagramme de la figure 3, portant la profondeur z en abscisses et le sens de $B_R$ en ordonnées.

La seconde technique de détection des inversions de l'induction rémanente, consiste à partir des courbes d'induction $B_L$ et $B_I$ et à calculer les valeurs absolues des gradients ou des dérivées premières $\dfrac{dB_L}{dz}$ et $\dfrac{dB_I}{dz}$ pour une base dz appropriée. Ce calcul permet de s'affranchir des grandes variations générales de ces inductions dues à la lithologie des roches et de ne retenir que les variations locales. On obtient ainsi deux profils de courbes $GB_L$ et $GB_I$ représentées sur la figure 4.

Pour chacune des courbes $GB_L$ et $GB_I$, on calcule ensuite des familles de courbes $L_i$ et $I_i$ paramétrées respectivement en fonction de la dérivée seconde de $B_L$ et de $B_I$.

A titre d'exemple, la courbe extrême $L_n$ passera par les valeurs maximales de $GB_L$; la courbe $I_n$ passera par les valeurs extrêmes de $GB_I$. On calcule le rapport :

$$K_i = \frac{L_i}{I_i}$$

A titre d'exemple, on calculera le rapport des valeurs des courbes extrêmes prises en valeur absolue :

$$K_n = \frac{L_n}{I_n}$$

La valeur de $K_i$ sera supérieure à 1 ou inférieure à 1 suivant la position relative des courbes $L_i$ et $I_i$.

Dans une configuration magnétique identique à celle rencontrée dans le Bassin Parisien, si $K_i > 1$, l'aimantation rémanente est du type normale (c'est-à-dire dans le sens de l'aimantation induite), si $K_i < 1$, l'aimantation rémanente est du type inverse (c'est-à-dire dans le sens opposé à l'aimantation induite). Dans d'autres configurations magnétiques rencontrées à la surface du globe, les conclusions pourraient être différentes.

On notera que la visualisation de $K_i$ est meilleure en représentant son logarithme. La polarité de $B_R$ est déterminée en fonction du signe du log ($K_i$).

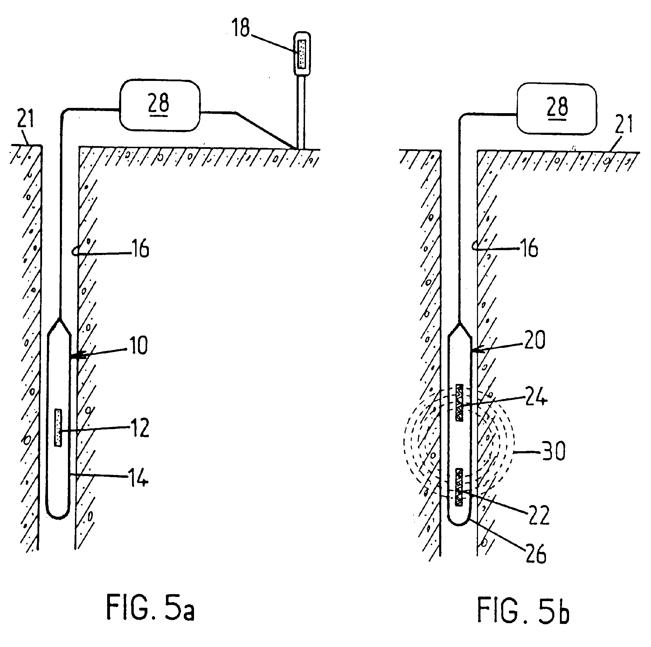

Les mesures et calculs mentionnés précédemment sont exécutés par un dispositif de traitement illustré schématiquement par les figures 5a et 5b. Ce dispositif comprend une première sonde 10 comprenant un capteur 12, par exemple à résonance magnétique nucléaire, enfermé dans un conditionnement 14 pour mesurer l'induction magnétique $B_1$ dans le trou de forage 16, à mesure qu'il se déplace dans ledit trou, un capteur 18, par exemple à résonance magnétique nucléaire, pour mesurer l'induction magnétique $B_2$ à la surface du sol 21 en un point fixe de façon simultanée à la mesure de $B_1$, une deuxième sonde 20 comprenant un émetteur 22 et un capteur 24 enfermés dans une enveloppe protectrice 26, pour mesurer la susceptibilité magnétique des roches dans le trou de forage pendant son déplacement dans le trou, et une unité d'enregistrement et de traitement de données 28 qui comprend des moyens permettant de calculer la grandeur $B_1 - B_2$, des moyens de filtrage de la grandeur $B_1 - B_2$ afin d'isoler la fraction d'induction $B_L$ qui ne contient que la composante $B_I$ due à l'aimantation induite et la composante $B_R$ due à l'aimantation rémanente, et des moyens permettant de calculer l'induction $B_I$ à partir de l'induction $B_1$ dans le trou et de la susceptibilité magnétique X. Sur la figure 5b, on a figuré en traits tiretés les lignes de champ magnétique 30.

Pour la mise en oeuvre de la première technique de détection exposée précédemment, on peut utiliser un dispositif comprenant des moyens pour tracer les courbes $B_L$ et $B_I$, des moyens pour faire subir à chaque pic de la courbe $B_I$ une translation $\overrightarrow{AA'}$ qui fait coïncider le point A de la courbe $B_I$ de plus faible valeur avec le point A' correspondant de la courbe $B_L$, et des moyens pour comparer l'évolution relative des courbes $B_L$ et $B_I$ ainsi positionnées.

Pour la seconde technique de détection on peut utiliser selon l'invention des moyens pour calculer les dérivées premières des inductions $B_L$ et $B_I$, des moyens pour tracer les valeurs absolues des courbes dérivées en fonction de la profondeur (la base de profondeur pouvant être variable), des moyens pour calculer et tracer les familles de courbes $L_i$ et $I_i$ paramétrées par la dérivée seconde des courbes $B_L$ et $B_I$, et des moyens pour calculer le rapport

$$K_i = \frac{L_i}{I_i}$$

et pour étudier sa valeur en fonction de la profondeur.

## Revendications

1. Procédé de détection des inversions du champ magnétique terrestre dans un trou de forage, du type dans lequel on mesure les variations de l'induction magnétique terrestre $B_1$ ainsi que la sus-

ceptibilité magnétique X des roches le long d'un trou de forage, caractérisé en ce qu'il consiste :

- à effectuer lesdites mesures en un grand nombre de points le long du trou de forage pour remontée en continu d'un appareil de mesure ;
- à mesurer simultanément les variations de l'induction magnétique $B_2$ en un point fixe à la surface du sol ;
- à former la grandeur $B_1$-$B_2$ afin d'éliminer les influences des variations temporelles de l'induction magnétique terrestre sur l'induction magnétique $B_1$ mesurée dans le trou ;
- à effectuer un filtrage de ladite grandeur afin d'éliminer la fraction d'induction due aux sources magnétiques lointaines, et d'isoler ainsi la fraction restante d'induction $B_L$ qui comprend une composante $B_I$ due à l'aimantation induite et une composante $B_R$ due à l'aimantation rémanente;
- à déduire des mesures de l'induction $B_1$ et de la susceptibilité magnétique X, l'induction $B_I$;
- et enfin à déduire des inductions $B_L$ et $B_I$ ainsi obtenues, l'influence des changements d'orientation de l'aimantation rémanente dans la roche.

2. Dispositif pour la mise en oeuvre du procédé selon la revendication 1, caractérisé en ce qu'il comprend :

- une première sonde (10) comprenant un capteur (12) pour mesurer l'induction magnétique $B_1$ dans le trou de forage (16) pendant son déplacement dans ledit trou;
- un capteur (18) pour mesurer l'induction magnétique $B_2$ à la surface du sol (21) en un point fixe de façon simultanée à la mesure de $B_1$;
- une deuxième sonde (20) pour mesurer la susceptibilité magnétique des roches dans le trou de forage pendant son déplacement dans ledit trou;
- une unité d'enregistrement et de traitement de données (28) qui comprend des moyens permettant de calculer la grandeur $B_1$-$B_2$, des moyens de filtrage de la grandeur $B_1$-$B_2$ afin d'isoler la fraction d'induction $B_L$ qui ne contient que la composante $B_I$ due à l'aimantation induite et la composante $B_R$ due à l'aimantation rémanente, et des moyens permettant de calculer l'induction $B_I$ à partir de l'induction $B_1$ dans le trou et de la susceptibilité magnétique X.

3. Dispositif selon la revendication 2, caractérisé en ce que les capteurs (12,18) sont constitués par des capteurs à résonance magnétique nucléaire.

4. Dispositif selon la revendication 2, caractérisé en ce qu'il comprend des moyens pour tracer les courbes $B_L$ et $B_I$, des moyens pour faire subir à chaque pic de la courbe $B_I$ une translation $\overrightarrow{AA'}$ qui fait coïncider le point A de la courbe $B_I$ de plus faible valeur au point A' correspondant de la courbe $B_L$ et des moyens pour comparer les amplitudes relatives des pics correspondants des courbes $B_L$ et $B_I$.

5. Dispositif selon la revendication 2, caractérisé en ce qu'il comprend des moyens pour calculer les dérivées premières des inductions $B_L$ et $B_I$, des moyens pour tracer les courbes dérivées de ces inductions en fonction de la profondeur, la base de profondeur pouvant être variable, des moyens pour calculer et tracer les familles de courbes $L_i$ et $I_i$ paramétrées par la dérivée seconde des courbes $B_L$ et $B_I$, des moyens pour prendre la valeur absolue de ces familles de courbes, et des moyens pour calculer le rapport $K_i = \dfrac{L_i}{I_i}$ et pour étudier sa valeur en fonction de la profondeur.

**Patentansprüche**

1. Verfahren zur Detektierung von Umkehrungen des erdmagnetischen Feldes in einem Bohrloch, bei dem die Änderungen der terrestrischen magnetischen Induktion $B_1$ sowie die magnetische Suszeptibilität X von Gesteinen entlang des Bohrlochverlaufes gemessen werden, **dadurch gekennzeichnet,**

- daß die Messungen an einer großen Anzahl von Punkten entlang des Bohrloches bei kontinuierlicher Aufwärtsbewegung eines Meßgerätes durchgeführt werden;
- daß gleichzeitig die Änderungen der magnetischen Induktion $B_2$ an einem Festpunkt auf der Bodenoberfläche gemessen werden;
- daß die Differenzgröße $B_1$-$B_2$ gebildet wird, um die Einflüsse zeitlicher Änderungen des erdmagnetischen Feldes auf die im Bohrloch gemessene magnetische Induktion $B_1$ zu eliminieren;
- daß eine Filtrierung der Differenzgröße durchgeführt wird, um den durch entfernte Magnetquellen entstehenden Induktionsanteil zu eliminieren und somit den verbleibenden Induktionsanteil $B_L$ auszusondern, der eine durch induzierte Magnetisierung entstehende Komponente $B_I$ und eine durch remanenten Magnetismus entstehende Komponente $B_R$ umfaßt;
- daß von den Induktionsmessungen $B_1$ und den magnetischen Suszeptibilitätsmessungen X die Induktion $B_i$ abgezogen wird;
- und daß schließlich von den somit gewonnenen Induktionswerten $B_L$ und $B_i$ der Einfluß der Richtungsänderungen der remanenten Magnetisierung im Gestein abgezogen wird.

2. Vorrichtung zur Durchführung des Verfahrens nach Anspruch 1, **dadurch gekennzeichnet,** daß sie enthält:
- eine erste Sonde (10), die eine Aufnehmereinrichtung (12) zum Messen der magnetischen Induktion $B_1$ im Bohrloch (16) während ihrer Verstellbewegung in diesem Bohrloch enthält;
- eine Aufnehmereinrichtung (18) zum Messen der magnetischen Induktion $B_2$ an einem Festpunkt auf der Bodenoberfläche (21) gleichzeitig mit der Messung von $B_1$;
- eine zweite Sonde (20) zum Messen der magnetischen Suszeptibilität des Gesteins entlang des Bohrloches während ihrer Verstellbewegung innerhalb des Bohrloches;
- eine Einheit (28) zur Aufzeichnung und Verarbeitung der Meßwerte, die Einrichtungen zur Berechnung der Differenzgröße $B_1$-$B_2$, Filtereinrichtungen für die Differengröße $B_1$-$B_2$ zur gesonderten Darstellung des Induktionsanteils $B_L$, der nur die aus der induzierten Magnetisierung entstehende Komponente $B_i$ und die aus der remanenten Magnetisierung entstehende Komponente $B_R$ enthält, sowie Einrichtungen zur Berechnung der Induktion $B_i$ aus der Induktion $B_1$ im Bohrloch und aus der magnetischen Suszeptibilität X umfaßt.

3. Vorrichtung nach Anspruch 2, dadurch gekennzeichnet, daß die Aufnehmereinrichtungen (12, 18) durch Aufnehmer für die magnetische Kernresonanz gebildet sind.

4. Vorrichtung nach Anspruch 2, dadurch gekennzeichnet, daß sie Einrichtungen umfaßt zum Aufzeichnen der Kurven $B_L$ und $B_i$, ferner Einrichtungen, die jeden Scheitel der Kurve $B_i$ einer Kurvenverschiebung A A' unterwerfen, durch die der Punkt A von geringerem Wert der Kurve $B_i$ mit dem entsprechenden Punkt A' der Kurve $B_L$ zur Übereinstimmung gelangt, sowie Einrichtungen zum Vergleich der relativen Amplituden der jeweiligen Scheitel der Kurven $B_L$ und $B_i$.

5. Vorrichtung nach Anspruch 2, dadurch gekennzeichnet, daß sie Einrichtungen enthält zum Berechnen der ersten Ableitungen der Induktionen $B_L$ und $B_i$, Einrichtungen zum Aufzeichnen der aus diesen Induktionen abgeleiteten Kurven in Abhängigkeit von der Tiefe, wobei die Tiefenbasis variabel sein kann, Einrichtungen zum Berechnen und Aufzeichnen der Kurvenscharen $L_i$ und $I_i$, die durch Berücksichtigung von Parametern für die zweite Ableitung der Kurven $B_L$ und $B_i$ entstehen, Einrichtungen zur Ermittlung des Absolutwertes dieser Kurvenscharen, und Einrichtungen zum Berechnen des Verhältnisses $K_i = L_i/I_i$ und zur Untersuchung seines Wertes in Abhängigkeit von der Bohrungstiefe.

**Claims**

1. Method of detecting the inversions of the terrestrial magnetic field in a drill hole, of the type in which the variations in the terrestrial magnetic induction $B_1$ as well as the magnetic susceptibility X of the rocks are measured along a drill hole, characterised in that it consists:
- in making the said measurements at a large number of points along the drill hole for continuous raising of a measurement apparatus;
- in simultaneously measuring the variations in the magnetic induction $B_2$ at a fixed point on the surface of the ground;
- in forming the quantity $B_1$ - $B_2$ so as to eliminate the influences of the time variations in the terrestrial magnetic induction on the magnetic induction $B_1$ measured in the hole;
- in carrying out a filtering of the said quantity so as to eliminate the fraction of induction due to the distant magnetic sources, and to thus isolate the remaining fraction of induction $B_L$ which comprises a component $B_i$ due to induced magnetisation and a component $B_R$ due to remanent magnetisation;
- in deducing from the measurements of the induction $B_1$ and of the magnetic susceptibility X, the induction $B_i$;
- and finally in deducing from the inductions $B_L$ and $B_i$ thus obtained, the influence of the changes of orientation of the remanent magnetisation in the rock.

2. Device for implementing the method according to Claim 1, characterised in that it comprises:
- a first probe (10) comprising a sensor (12) for measuring the magnetic induction $B_1$ in the drill hole (16) during its motion in the said hole;
- a sensor (18) for measuring the magnetic induction $B_2$ on the surface of the ground (21) at a fixed point simultaneously with the measuring of $B_1$;

- a second probe (20) for measuring the magnetic susceptibility of the rocks in the drill hole during its motion in the said hole;

- a data recording and processing unit (28) which comprises means allowing calculation of the quantity $B_1 - B_2$, means for filtering the quantity $B_1 - B_2$ so as to isolate the fraction of induction $B_L$ which contains only the component $B_I$ due to induced magnetisation and the component $B_R$ due to remanent magnetisation, and means allowing calculation of the induction $B_I$ from the induction $B_1$ in the hole and from the magnetic susceptibility X.

3. Device according to Claim 2, characterised in that the sensors (12, 18) consist of nuclear magnetic resonance sensors.

4. Device according to Claim 2, characterised in that it comprises means for plotting the curves $B_L$ and $B_I$, means for subjecting each peak of the curve $B_I$ to a translation $\overrightarrow{AA'}$, which merges the point A of the curve $B_I$ of smaller value with the corresponding point A' of the curve $B_L$ and means for comparing the relative amplitudes of the corresponding peaks of the curves $B_L$ and $B_I$.

5. Device according to Claim 2, characterised in that it comprises means for calculating the first derivatives of the inductions $B_L$ and $B_I$, means for plotting the derived curves of these inductions as a function of depth, it being possible for the depth basis to vary, means for calculating and plotting the families of curves $L_i$ and $I_i$ parametrized by the second derivative of the curves $B_L$ and $B_I$, means for taking the absolute value of these families of curves, and means for calculating the ratio $K_i = \dfrac{L_i}{I_i}$ and for studying its value as a function of depth.

FIG.1

FIG.2a

FIG.2b

FIG.2c

Aimantation rémanente Normale

Aimantation rémanente Inverse

FIG. 3

Dérivée en nT/m

$GB_L$

$GB_I$

$I_i$

$L_i$

FIG 4

FIG. 5a

FIG. 5b